# EUROPEAN PATENT SPECIFICATION

(11) **EP 2 109 137 B1**
(45) Date of publication and mention of the grant of the patent: **03.06.2015**
(21) Application number: 08163171.5
(22) Date of filing: 28.08.2008
(51) Int. Cl.: H01L 23/31, H01L 23/29, H01L 51/52

(54) **Graded composition encapsulation thin film comprising anchoring layer and method of fabricating the same**
Verkapselungsdünnschicht mit abgestufter Zusammensetzung mit Verankerungsschicht und Herstellungsverfahren dafür
Film mince à encapsulation de composition graduée comprenant une couche d'ancrage et son procédé de fabrication

(30) Priority: 10.04.2008 KR 20080033400
(43) Date of publication of application: 14.10.2009
(73) Proprietor: Samsung Electronics Co., Ltd., Suwon-si, Gyeonggi-do, 443-742 (KR)
(72) Inventor: Choi, Yun Hyuk, 449-712 Gyeonggi-do (KR); Lee, Kwang Hee, 449-712 Gyeonggi-do (KR); Bae, Hyung Jin, 449-712 Gyeonggi-do (KR); Park, Jong Jin, 449-712 Gyeonggi-do (KR); Bulliard, Xavier, 449-712 Gyeonggi-do (KR)
(74) Representative: Zijlstra, Robert Wiebo Johan

(56) References cited:
- US-A1- 2004 046 497

## Description

This invention as claimed in claim 1 is directed to a graded composition encapsulation thin film (hereinafter also referred to simply as an 'encapsulation thin film') comprising an anchoring layer and a method of fabricating the encapsulation thin film as claimed in claim 8. More specifically, the encapsulation thin film comprises an anchoring layer including a Si-containing organic-inorganic hybrid polymer, and a graded composition layer including two or more compounds selected from the group consisting of metal oxides, metal nitrides and silicon oxides whose composition is continuously changed in the vertical direction to achieve excellent barrier properties against the permeation of moisture and oxygen and to effectively block the introduction of harmful external contaminants.

Electronic display devices, such as organic light emitting diodes ("OLEDs") and liquid crystal displays ("LCDs"), typically include organic materials that are highly sensitive to oxygen or water vapor in air. Electronic display devices can suffer from power reduction or early performance degradation when exposed to oxygen or water vapor. To protect against such circumstances, a number of methods have been developed for the protection of electronic display devices that use metals and glass as environmental barriers to prolong the lifetime of the devices. However, metals and glass have disadvantages when used in such applications with regard to transparency and flexibility, respectively. Thus, there is a need to develop flexible transparent barrier films or encapsulation thin films suitable for use in the encapsulation of thin, lightweight and bendable flexible OLEDs and other electronic devices.

Disclosed herein is a graded composition encapsulation thin film comprising a substrate, a graded composition layer and an anchoring layer interposed therebetween wherein the anchoring layer includes a Si-containing organic-inorganic hybrid polymer.

The anchoring layer serves to increase the adhesion between the graded composition layer and the substrate and improve the ability to prevent permeation of oxygen and moisture.

The encapsulation thin film is useful in providing acid resistance, transparency and flexibility in electronic devices.

Also disclosed is a graded composition encapsulation thin film comprising a substrate, a graded composition layer including two or more compounds selected from the group consisting of metal oxides, metal nitrides and silicon oxides, wherein a composition of the graded composition layer continuously changes in a vertical direction to form a compositional gradient, and the graded composition layer is continuous with no observable interface, and an anchoring layer interposed between the substrate and the graded composition layer, wherein the anchoring layer includes a Si-containing organic-inorganic hybrid polymer.

Further disclosed is a method for the fabrication of a graded composition encapsulation thin film, comprising: coating a Si-containing organic-inorganic hybrid polymer on a substrate and heat-curing the coating to form an anchoring layer; and forming a graded composition layer on the anchoring layer by physical vapor deposition ("PVD") by multi-target PVD deposition.

According to the method, the use of the multi-target allows deposition of high-quality, extremely uniform, thin film multi-layer or graded stacks which facilitate the fabrication of a graded composition encapsulation thin film by PVD. In an example, the graded composition layer is continuous with no observable interface.

Also disclosed is an electronic device with increased lifetime, comprising the encapsulation thin film.

US 2004/046497 discloses a silicone (i.e. a polysiloxane) substrate having a graded inorganic layer thereon. Processing has been carried out to create a "diffuse layer" interfaced between the substrate and the graded layer.

The exemplary implementations will be more clearly understood from the following detailed description taken in conjunction with the accompanying drawings, where:
FIG. 1 is a schematic sectional view of an exemplary graded composition encapsulation thin film;
FIG. 2 is another schematic sectional view of an exemplary graded composition encapsulation thin film;
FIG. 3 is a schematic sectional view of an exemplary graded composition encapsulation thin film prepared in Example 1;
FIG. 4 is a graph showing the composition distribution tendency of an exemplary graded composition layer formed in Example 1 along the vertical direction;
FIG. 5 shows depth profiles illustrating aluminum, oxygen and silicon distributions in an exemplary graded composition layer formed in Example 1 along the vertical direction, as measured by Auger electron spectroscopy ("AES");
FIG. 6 is a cross-sectional FE-SEM image of an exemplary graded composition encapsulation thin film prepared in Example 1;
FIG. 7 is a cross-sectional view of an exemplary graded composition encapsulation thin film prepared in Example 2;
FIG. 8 is a graph showing the composition distribution tendency of an exemplary graded composition layer formed in Example 2 along the vertical direction;
FIG. 9 shows depth profiles illustrating aluminum, oxygen and silicon distributions in an exemplary graded composition layer formed in Example 2 along the vertical direction, as measured by Auger electron spectroscopy (AES);
FIG. 10 is a cross-sectional FE-SEM image of an exemplary graded composition encapsulation thin film prepared in Example 2; and
FIG. 11 is a graph showing the variations in the transmittance of exemplary graded composition encapsulation thin films prepared in Examples 1 and 2.

Hereinafter, a detailed description will be given of examples with reference to the accompanying drawings.

It will be understood that when an element or layer is referred to as being "on," "interposed," "disposed," or "between" another element or layer, it can be directly on, interposed, disposed, or between the other element or layer or intervening elements or layers may be present.

It will be understood that, although the terms first, second, third, and the like may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, first element, component, region, layer or section discussed below could be termed second element, component, region, layer or section without departing from the teachings of the present invention.

As used herein, the singular forms "a," "an" and "the" are intended to comprise the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In an example, a graded composition encapsulation thin film comprises a substrate, a graded composition layer, and an anchoring layer interposed therebetween wherein the anchoring layer includes a Si-containing organic-inorganic hybrid polymer.

With this configuration of the encapsulation thin film, the anchoring layer plays a role in relieving stress between the substrate and the graded composition layer to prevent the occurrence of cracks within the graded composition layer, and improves the adhesion between the substrate and the graded composition layer to enhance the ability to prevent permeation of moisture and oxygen. In addition, the presence of the anchoring layer allows for the uniform formation of the graded composition layer, and allows the graded composition layer to be densely stacked to a thickness greater than a predetermined level.

The graded composition layer comprises two or more compounds selected from the group consisting of metal oxides, metal nitrides and silicon oxides, where the proportions of the two or more compounds in the graded composition layer changes continuously along the vertical direction of the graded composition layer to form a compositional gradient. As used herein, the term "gradient" describes a change in composition of two or more components of the film along a vertical (i.e., z-axis) dimension of a film (i.e., orthogonal to the x-y plane of a substrate on which the film is deposited), where a first composition of one or more of the compounds is enriched at the interface of the graded composition layer at the anchor layer, and is displaced by a second composition of one or more different compounds, to change the overall composition of the graded composition layer along the vertical direction to the interface opposite that with the anchor layer. The constituent compounds of the graded composition layer act to block the introduction of external contaminants such as oxygen and harmful ingredients into the encapsulation thin film, and the continuous change in the composition along the vertical direction prevents the occurrence of a discontinuous layer that would otherwise occur with interfaces formed between discrete compositional layers, thereby ensuring excellent barrier properties for the graded composition layer.

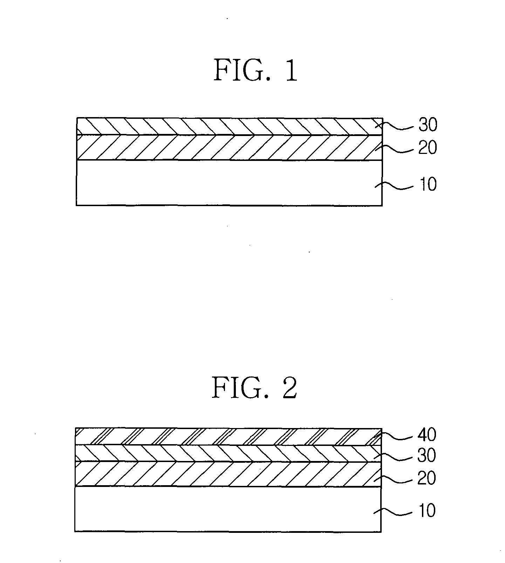

FIG. 1 is a schematic cross-sectional view of and exemplary encapsulation thin film. Referring to FIG. 1, the encapsulation thin film comprises a substrate 10, an anchoring layer 20 formed on a surface of the substrate 10, and a graded composition layer 30 formed on a surface of the anchoring layer 20 opposite the substrate 10 wherein the anchoring layer 20 includes a Si-containing organic-inorganic hybrid polymer and the graded composition layer 30 includes two or more compounds selected from the group consisting of metal oxides, metal nitrides and silicon oxides, the composition of which changes continuously along a compositional gradient in the vertical direction.

The substrate 10 is not particularly limited and may be any substrate commonly used in electronic devices. Any substrate that can be utilized in packaging applications may also be used. Examples of materials for the substrate 10 include, but are not necessarily limited to, polyoxymethylene, polyvinyl naphthalene, polyetherketone, fluorinated polymers, poly(α-methylstyrene), polysulfone, polyphenylene oxide, polyetherimide, polyethersulfone, polyamideimide, polyimide, polyphthalamide, polycarbonate, polyarylate, polyethylene naphthalate, and polyethylene terephthalate.

The anchoring layer 20 in the encapsulation thin film increases the adhesion between the organic plastic substrate 10 and the inorganic graded composition layer 30 causes a decrease in the permeation rates of oxygen, water vapor and other chemical species present in ambient air.

The encapsulation thin film can have a light transmittance greater than or equal to 85% in the visible region (measured with a CARY 5000 UV-VIS spectrometer, VARIAN).

In an example, the anchoring layer 20 includes both organic and inorganic materials to increase the interfacial adhesion between the inorganic layer and the organic substrate. In a specific example, the anchoring layer 20 includes at least one polymer selected from the group consisting of polysiloxanes, polysilsesquioxanes, and polysilazanes, to improve the adhesion at the interface and achieve high flexibility.

The polysiloxanes are represented, in an example, by the following Formula (1): 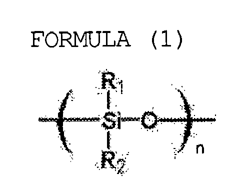 wherein R₁ and R₂ are each independently a hydrogen atom, a C₁-C₃ alkyl group, a C₃-C₁₀ cycloalkyl group, or a C₆-C₁₅ aryl group, and n is an integer from 2,000 to 200,000. One skilled in the art will appreciate that, as used herein, values used to specify degrees of polymerization such as n represent an average value of a distribution of degrees of polymerization for oligomers of the polysiloxane.

The polysilsesquioxanes are represented, in an example, by the following Formula (2): 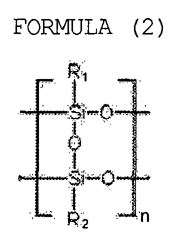 wherein R₁ and R₂ are each independently a hydrogen atom, a C₁-C₃ alkyl group, a C₃-C₁₀ cycloalkyl group, or a C₆-C₁₅ aryl group, and n is an integer from 2,000 to 200,000.

The polysilazanes are represented, in an example, by the following Formula (3):

FORMULA (3) -(SiR₁R₂-NR₃)ₙ-
wherein R₁, R₂ and R₃, which may be the same or different, each independently represent a hydrogen atom, a C₁-C₅ alkyl group, a C₂-C₅ alkenyl group, a C₂-C₅ alkynyl group, an alkoxy group or a C₃-C₈ aromatic group, with the proviso that at least one of R₁, R₂ and R₃ is a hydrogen atom, and n is an integer from 500 to 1,000,000.

In a specific embodiment, polysilazanes can be selected from the group consisting of polymers represented by the following Formulas (4), (5) and (6): 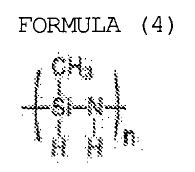 wherein n is an integer from 500 to 1,000,000; 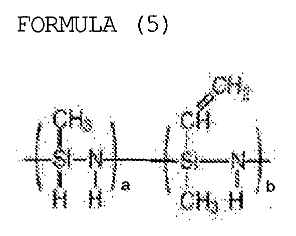 wherein a and b are each independently an integer from 250 to 500,000; and 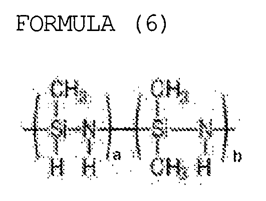 wherein a and b are each independently an integer from 250 to 500,000.

The amino groups present in the backbone of the polysilazanes convert to silica in the presence of water and active oxygen species. The terminal CH₃ groups or the equivalent functional groups thereof have a significant effect on the improvement of the adhesion to the organic substrate and the improvement in the flexibility of the anchoring layer.

The interlayer insulating material disposed between electrode lines is a Si-containing organic-inorganic polymeric material and is not otherwise limited so long as it contains silicon atoms. Specific examples of Si-containing organic-inorganic polymeric materials include hydrogen silsesquioxane ("HSQ"), methylsilsesquioxane ("MSQ") and hydrido-organosiloxane polymers ("HOSP"), but are not necessarily limited thereto.

As described above, the graded composition layer 30 is formed on a surface of the anchoring layer 20 (opposite the substrate 10), and includes two or more compounds selected from the group consisting of metal oxides, metal nitrides, and silicon oxides, the composition of which continuously changes in a gradient in the vertical direction.

In an example, the content of at least one of the compounds selected for the composition of the graded composition layer 30 increases with a corresponding decrease in the content of the other compound(s) present in the vertical direction of the graded composition layer. In an alternative example, the content of a compound selected for the composition of the graded composition layer 30 can be fixed, with an increasing or decreasing content of the other compound(s) in the vertical direction.

The metal oxides, metal nitrides, and silicon oxides include one or more metals selected from the group consisting of Group 2A, 3A, 4A, 5A, 6A, 7A, 8A, 1B, 2B, 3B, and 4B elements.

FIG. 2 is another exemplary schematic sectional view of the encapsulation thin film. Referring to FIG. 2, the encapsulation thin film comprises a substrate 10, an anchoring layer 20 formed on a surface of the substrate 10, a graded composition layer 30 formed on a surface of the anchoring layer 20 opposite the substrate 10, and a protective layer 40 formed on a surface of the graded composition layer 30 opposite anchoring layer 20, wherein the anchoring layer 20 includes a Si-containing organic-inorganic hybrid polymer and the graded composition layer 30 includes two or more compounds selected from the group consisting of metal oxides, metal nitrides, and silicon oxides, the composition of which continuously changes in the vertical direction along a compositional gradient.

The protective layer 40 serves to protect the surface of the graded composition layer from being damaged and includes at least one polymer selected from the group consisting of, but necessarily not limited to, fluorinated polymers, silicone polymers, and lipophilic polymers.

A method for the fabrication of a graded composition encapsulation thin film is provided. Specifically, the method comprises: coating a Si-containing organic-inorganic hybrid polymer on a substrate and heat-curing the resulting coating to form an anchoring layer; and forming a graded composition layer on the anchoring layer by physical vapor deposition (PVD) by multi-target PVD deposition.

In an example of the method, a solution of a Si-containing organic-inorganic hybrid polymer in an organic solvent is applied to a substrate, followed by heat curing at 50 to 100°C for 30 seconds to 3 hours to form an anchoring layer.

Examples of organic solvents capable of dissolving the hybrid polymer to prepare the coating solution include, but are not particularly limited to: aromatic hydrocarbon solvents, such as anisole and xylene; ketone-based solvents, such as methyl isobutyl ketone and acetone; ether-based solvents, such as tetrahydrofuran and isopropyl ether; silicon-based solvents; and mixtures thereof. The solvent is used in an amount such that the solid content of the coating solution is 0.1 to 80% and specifically 5 to 30% by weight of the total weight of the coating solution.

Suitable coating processes for applying the coating solution containing the organic-inorganic hybrid material to the substrate include drop casting, spin coating, dip coating, spray coating, flow coating and screen printing, though not limited thereto.

Next, two or more compounds selected from the group consisting of metal oxides, metal nitrides and silicon oxides are deposited on the anchoring layer in a PVD system to form a graded composition layer in which the composition of the two or more compounds continuously changes in the vertical direction to form compositional gradient.

Suitable PVD processes for the deposition of the graded composition layer include, but are not necessarily limited to, sputtering, pulsed laser deposition ("PLD"), ion beam deposition ("IBD") and ion beam assisted deposition ("IBAD").

The PVD process can also be carried out by co-deposition by multi-target PVD deposition. Specific examples of such co-deposition processes include, but are not necessarily limited to, co-pulsed laser deposition ("co-PLD"), co-ion beam deposition ("co-IBD") and co-ion beam assisted deposition ("co-IBAD").

Specifically, when it is desirable to form the graded composition layer by co-sputtering, different radio frequency ("RF") power levels are supplied to two or more compound targets. At this time, the RF power levels are varied at constant power and time intervals such that the composition gradient of the compounds in the graded composition layer can be continuously increased or decreased in the vertical (thickness) direction of deposition, to form a compositional gradient. In an example, the graded composition layer is continuous with no observable interface. As used herein, the term "observable" means that the no distinct interface can be seen by an analytical method such as, for example, by field emission scanning electron microscopy, within the graded composition layer.

The RF power levels are allowed to be varied in an instantaneous and automatic manner to form the graded composition layer and thereby to avoid formation of any interface as would be obtained by successive deposition of compositionally discrete layers, and as a result, a graded composition encapsulation thin film with a transmittance equal to or greater than 85% in the visible light region (i.e., about 380 to about 750 nm wavelength) can be prepared.

The RF power levels can be regulated such that the content of a compound selected for the composition of the graded composition layer increases with decreasing content of the other compound(s). Alternatively, the content of a compound selected for the composition of the graded composition layer can be fixed with varying (increasing or decreasing) content of the other compound(s).

In an example, the method can further comprise forming a protective layer 40 on a surface of the graded composition layer 30 opposite anchor layer 20.

The protective layer 40 can be formed by dissolving or dispersing a material including at least one polymer selected from the group consisting of fluorinated polymers, silicone polymers, and lipophilic polymers in a suitable solvent, applying the solution to a surface of the graded composition layer 30, and heat-curing the coating at about 50 to about 100°C for about 30 seconds to about 3 hours.

The encapsulation thin film has the ability to prevent permeation of oxygen and moisture and is highly resistant to diffusion of other chemical species. Therefore, the use of the encapsulation thin film for the encapsulation of a variety of electronic devices is effective in prolonging the lifetime of the electronic devices.

Examples of electronic devices that can employ the encapsulation thin film include organic light-emitting devices, display devices, photovoltaic devices, integrated circuits, pressure sensors, chemosensors, biosensors, solar-powered devices and devices for lighting, but are not necessarily limited thereto.

A better understanding of exemplary implementations will be described in more detail with reference to the following examples. These examples are exemplary and are provided for the purpose of illustration only.

### EXAMPLES

### Example 1: Preparation of graded composition encapsulation thin film.

The organic-inorganic hybrid siloxane polymer (1.16 g) of the following Formula 7 was dissolved in propylene glycol monomethyl ether acetate (PGMEA, 3.87 g) to prepare a coating solution having a solids content of 23 wt%: 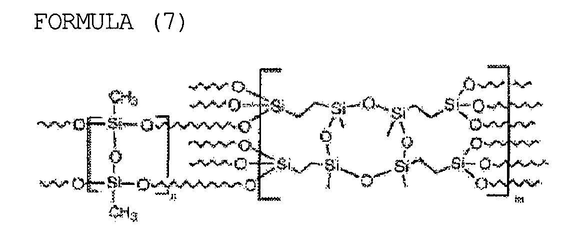 wherein n and m are each independently an integer from 50 to 500,000.

The coating solution was spin-coated on a 100 µm thick polyethylene terephthalate ("PET") substrate. Subsequently, the coating was heat-cured by sequentially heating on a hot plate at 50°C for 5 minutes and in an oven at 60°C for 2 hours, to form an anchoring layer.

Next, an Al₂O₃-SiO₂ graded composition layer was formed on the exposed surface of the anchoring layer in a deposition system (Sputter Infovion No. 3, available from Infovion, with a 2 gun co-sputtering, 6 inch (15.24 cm) substrate) to produce a graded composition encapsulation thin film. The Al₂O₃-SiO₂ graded composition layer was formed by applying increasing RF power from 100 watts (W) to 600 W at constant intervals to an Al₂O₃ target, gradually increasing the Al₂O₃ concentration, while decreasing RF power applied to a SiO₂ target from 600 W to 100 W at constant intervals to gradually decrease the SiO₂ concentration during deposition.

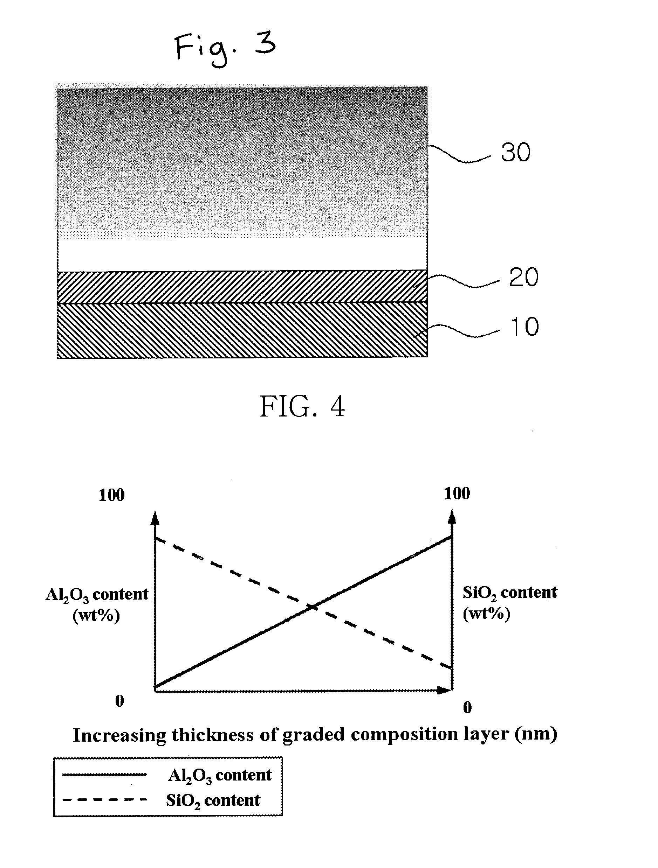

A cross-sectional view of the encapsulation thin film is schematically shown in FIG. 3. Referring to FIG. 3, the encapsulation thin film comprises the substrate 10, the anchoring layer 20 and the graded composition layer 30 stacked in this order from the bottom, where the Al₂O₃-SiO₂ composition of the graded composition layer 30 continuously changes in the vertical (thickness) direction to provide an Al₂O₃-SiO₂ compositional gradient. The compositional gradient is depicted schematically as shading in graded composition layer 30 in FIG. 3.

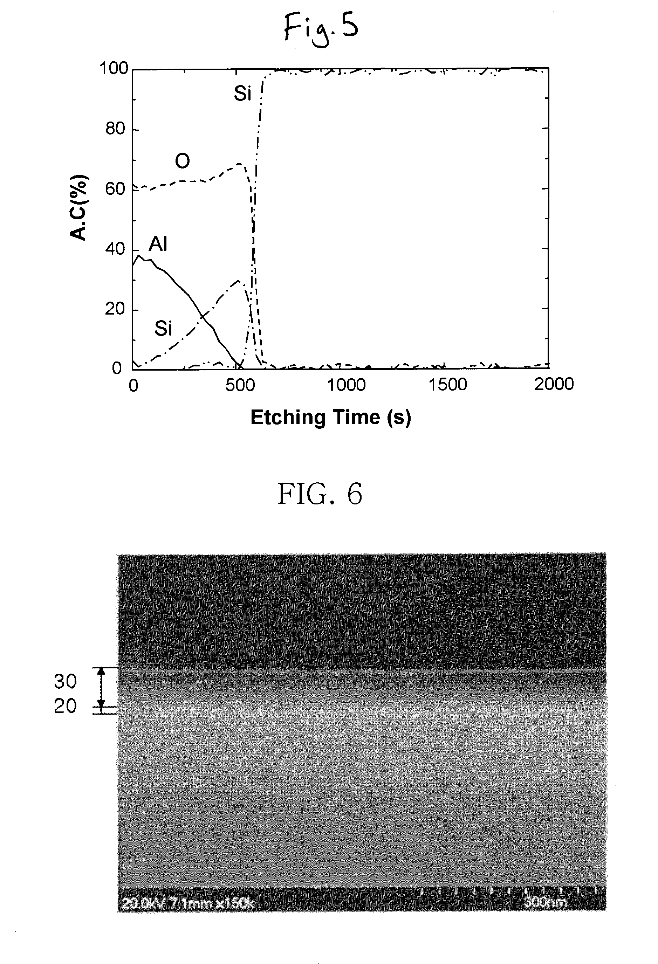

FIG. 4 is a graph showing the composition distribution tendency of the graded composition layer along the vertical direction, and FIG. 5 shows depth profiles illustrating aluminum, oxygen and silicon distributions in the graded composition layer along the vertical direction, as measured by Auger electron spectroscopy (AES). These graphs reveal that the Al₂O₃ content increased and the SiO₂ content decreased gradually from the bottom to the surface, and that the layers formed in the respective deposition steps had almost the same thickness, which accounts for the uniform thickness of the graded composition layer.

FIG. 6 is a cross-sectional field emission scanning electron microscope ("FE-SEM") image of the encapsulation thin film. The image shows that where the encapsulation thin film had a total thickness of 78 nm, the anchoring layer had a uniform thickness of about 30 nm ("20" in FIG. 6), and the graded composition layer ("30" in FIG. 6) was uniformly formed with no interface on the anchoring layer.

### Example 2: Preparation of graded composition encapsulation thin film.

An anchoring layer was formed in the same manner as in Example 1. An Al₂O₃-SiO₂ graded composition layer was formed on the anchoring layer in a deposition system (Sputter Infovion No. 3, available from Infovion, 2 gun co-sputtering, 6 inch (15.24 cm) substrate) to produce a graded composition encapsulation thin film. Specifically, the Al₂O₃-SiO₂ graded composition layer was formed by applying decreasing RF power to an SiO₂ target from 600 W to 100 W at constant intervals, thereby gradually decreasing the SiO₂ content, while applying fixed RF power to an Al₂O₃ target at a level of 600 W to maintain deposition of the Al₂O₃ unchanged.

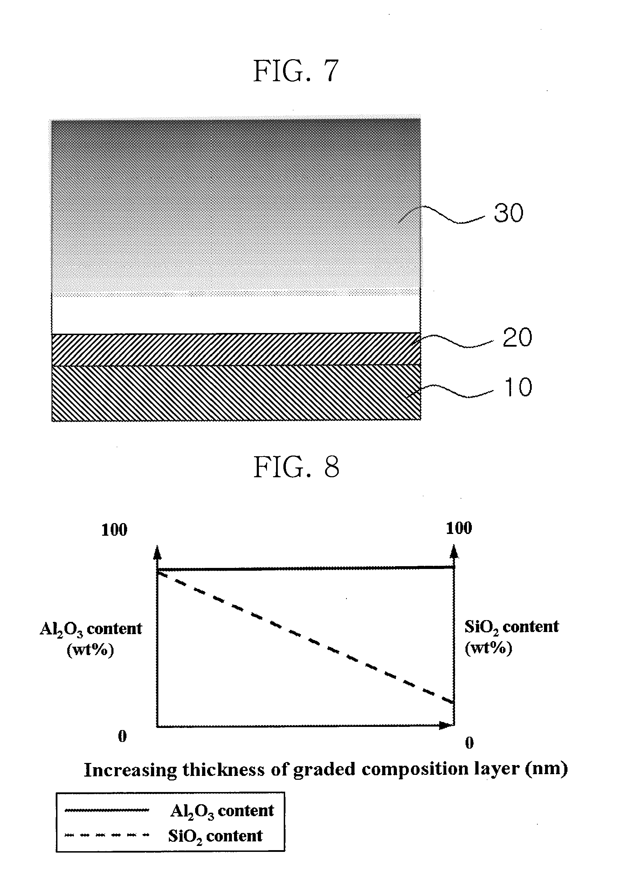

A cross-sectional view of the encapsulation thin film is schematically shown in FIG. 7. Referring to FIG. 7, the encapsulation thin film comprises the substrate 10, the anchoring layer 20 disposed on a surface of the substrate 10, and the graded composition layer 30 disposed on a surface of the anchor layer 20 opposite the substrate 10, the layers stacked in this order from the bottom, and where the Al₂O₃-SiO₂ composition of the graded composition layer 30 continuously changes in the vertical direction to form a concentration gradient.

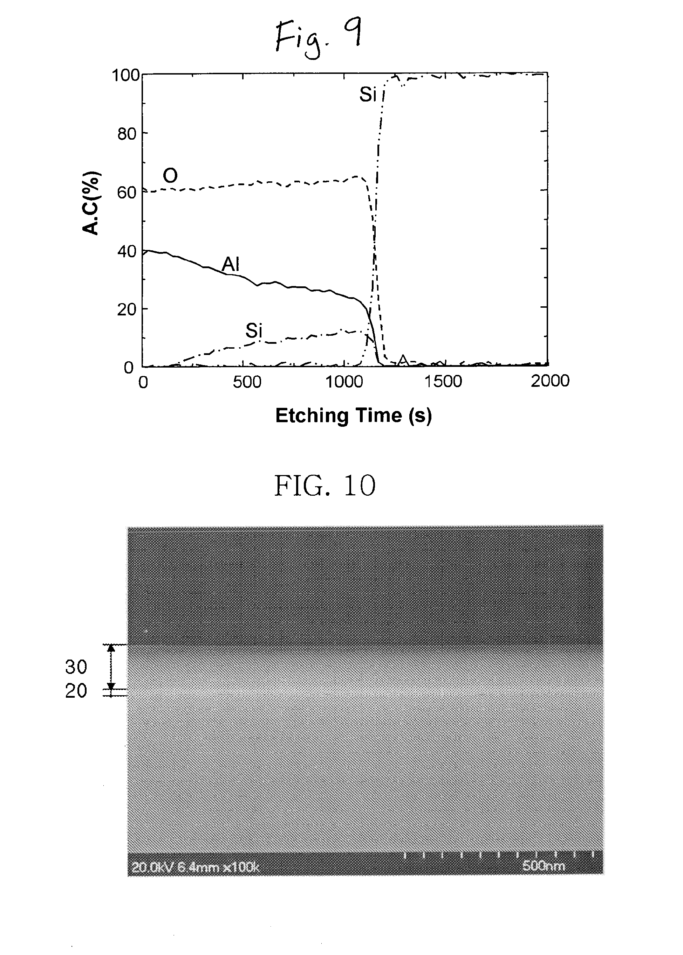

FIG. 8 is a graph showing the composition distribution tendency of the graded composition layer along the vertical direction, and FIG. 9 shows depth profiles illustrating aluminum, oxygen and silicon distributions in the graded composition layer along the vertical direction, as measured by Auger electron spectroscopy (AES). These graphs reveal that where the Al₂O₃ content was maintained at a constant level and the SiO₂ content was decreased gradually from the bottom to the surface, a relative increase in the Al₂O₃ concentration results.

FIG. 10 is a cross-sectional FE-SEM image of the encapsulation thin film. The image shows that the encapsulation thin film had a total thickness of 135 nm, the anchoring layer ("20" in FIG. 10) had a uniform thickness of about 30 nm, and the graded composition layer ("30" in FIG. 10) exhibited substantially no interface with the anchoring layer.

### Comparative Example 1: Preparation of graded composition encapsulation thin film with no anchoring layer.

An Al₂O₃-SiO₂ graded composition layer was formed on a 100 µm thick polyethylene terephthalate (PET) substrate in a deposition system (Sputter Infovion No. 3, available from Infovion, 2 gun co-sputtering, 6 inch (15.24 cm) substrate) to produce a graded composition encapsulation thin film. The Al₂O₃-SiO₂ graded composition layer was formed by applying increasing RF power to an Al₂O₃ target of from 100 W to 600 W at constant intervals, gradually increasing the Al₂O₃ concentration, while applying decreasing RF power applied to a SiO₂ target from 600 W to 100 W at constant intervals, gradually decreasing the SiO₂ concentration.

### Comparative Example 2: Preparation of graded composition encapsulation thin film with no anchoring layer.

An Al₂O₃-SiO₂ graded composition layer was formed on a 100 µm thick polyethylene terephthalate (PET) substrate in a deposition system (Sputter Infovion No. 3, available from Infovion, 2 gun co-sputtering, 6 inch (15.24 cm) substrate) to produce a graded composition encapsulation thin film. Specifically, the Al₂O₃-SiO₂ graded composition layer was formed by applying decreasing RF power to a SiO₂ target from 600 W to 100 W at constant intervals, gradually decreasing the SiO₂ content, while applying fixed RF power to an Al₂O₃ target at a level of 600 W to maintain a constant Al₂O₃ deposition.

### Comparative Example 3: Preparation of Al₂O₃ thin film comprising anchoring layer

The organic-inorganic hybrid siloxane polymer (1.16 g) of the following Formula 7 was dissolved in propylene glycol monomethyl ether acetate (PGMEA, 3.87 g) to prepare a coating solution having a solid content of 23 wt%. 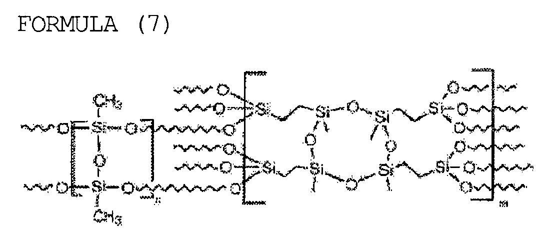 wherein n and m are each independently an integer from 50 to 500,000.

The coating solution was spin-coated on a 100 µm thick polyethylene terephthalate (PET) substrate. The coating was heat-cured by sequentially heating on a hot plate at 50°C for 5 minutes and in an oven at 60°C for 2 hours to form an anchoring layer.

Next, Al₂O₃ was deposited to a thickness of 135 nm on the anchoring layer with a deposition system (Sputter Infovion No. 3, available from Infovion, 2 gun co-sputtering, 6 inch (15.24 cm) substrate) to produce an encapsulation thin film. The Al₂O₃ layer was formed by applying RF power at a fixed level of 600 W to an Al₂O₃ target.

### Comparative Example 4: Preparation of SiO₂ thin film comprising anchoring layer.

The organic-inorganic hybrid siloxane polymer (1.16 g) of the following Formula 7 was dissolved in propylene glycol monomethyl ether acetate (PGMEA, 3.87 g) to prepare a coating solution having a solid content of 23 wt%. 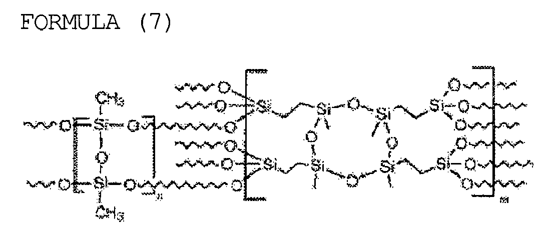 wherein n and m are each independently an integer from 50 to 500,000.

The coating solution was spin-coated on a 100 µm thick polyethylene terephthalate (PET) substrate. The coating was heat-cured by heating sequentially on a hot plate at 50°C for 5 minutes and in an oven at 60°C for 2 hours to form an anchoring layer.

Next, SiO₂ was deposited to a thickness of 135 nm on the anchoring layer in a deposition system (Sputter Infovion No. 3, available from Infovion, 2 gun co-sputtering, 6 inch (15.24 cm) substrate) to produce an encapsulation thin film. The SiO₂ layer was formed by applying RF power at a fixed level of 600 W to a SiO₂ target.

### Characterization of encapsulation thin films

### Water vapor transmission rate (WVTR)

The water vapor transmission rates (WVTR) of the encapsulation thin films prepared in Examples 1 and 2 and Comparative Examples 1 to 4 were measured with an AQUATRAN® Model 1 system (MOCON) at 37.8°C and 100% relative humidity (RH). The results are shown in Table 1.

**TABLE 1**

| | Water vapor transmission rate (g/m²·day) |
|---|---|
| Example 1 | 0.01-0.05 |
| Example 2 | 0.007-0.008 |
| Comparative Example 1 | 5-7 |
| Comparative Example 2 | 3-5 |
| Comparative Example 3 | 0.1-0.2 |
| Comparative Example 4 | 0.6-0.7 |

The results in Table 1 show that the water vapor transmission rates of the encapsulation thin films with an anchoring layer (Examples 1 and 2) were a maximum of 1,000 times higher than those of the encapsulation thin films with no anchoring layer (Comparative Examples 1 and 2), indicating that the encapsulation thin films of Examples 1 and 2 had improved barrier properties. Further, the water vapor transmission rate of the encapsulation thin film prepared in Example 2, which comprises an anchoring layer and a graded composition layer formed on the anchoring layer, was about 10 times higher than the water vapor transmission rates of the encapsulation thin films prepared in Comparative Examples 3 and 4, each comprising a single composition layer having the same thickness as the graded composition layer. From these results it can be seen that the anchoring layer and the graded composition layer contributed to the improved barrier properties of the thin films of the graded composition layers.

### Evaluation of anti-bending properties.

The adhesion between the graded composition layer and the anchoring layer in each of the encapsulation thin films prepared in Examples 1 and 2 was measured. Specifically, repeated bending tests on the encapsulation thin films prepared in Examples 1 and 2 and Comparative Examples 1 and 2 were conducted with a Minimat (Minimal tensile tester with controlled displacement) system (Rheometric Scientific). The results are shown in Table 2.

**TABLE 2**

| | Thickness (nm) of anchoring layer | Thickness (nm) of graded composition layer | Density of cracks (mm⁻¹) observed under optical microscope after 500 repeated bending cycles |
|---|---|---|---|
| Example 1 | 30 | 78 | 40-50 |
| Example 2 | 30 | 135 | 70-80 |
| Comparative Example 1 | - | 78 | 110-120 |
| Comparative Example 2 | - | 135 | 130-140 |

From the results in Table 2, it can be seen that the crack density of the encapsulation thin films prepared in Examples 1 and 2 was lower than that of the encapsulation thin films (Comparative Examples 1 and 2) with no anchoring layer, indicating that the anchoring layer improved the interfacial adhesion between the graded composition layer and the substrate in the encapsulation thin films prepared in Examples 1 and 2. The crack density of the encapsulation thin films prepared in Example 2 and Comparative Example 2, whose graded composition layer was relatively thick, was higher than that of the encapsulation thin films prepared in Example 1 and Comparative Example 1, whose graded composition layer was relatively thin.

### Measurement of transmittance

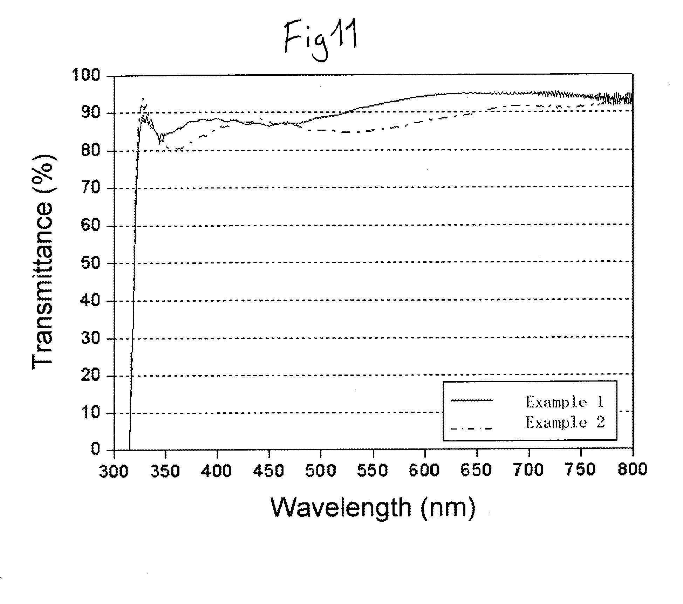

The transmittance of the graded composition encapsulation thin films prepared in Examples 1 and 2 was measured with a CARY 5000 UV-VIS spectrometer (VARIAN). The results are shown in FIG. 11. The graph of FIG. 11 shows that the thin films had a high transmittance of 85-90% in the visible region. Therefore, it can be seen that the encapsulation thin films prepared in Examples 1 and 2 are suitable for use in the encapsulation thin film of electronic devices.

Although examples have been disclosed for illustrative purposes, those skilled in the art will appreciate that various modifications, additions and substitutions are possible, without departing from the scope of the invention as disclosed in the accompanying claims.

## Claims

1. A graded composition encapsulation thin film comprising a substrate (10), an anchoring layer (20) formed on a surface of the substrate and a graded composition layer (30) formed on a surface of the anchoring layer opposite the substrate, wherein the anchoring layer is formed of a Si-containing organic-inorganic hybrid polymer.

2. The encapsulation thin film of claim 1, wherein the graded composition layer (30) includes two or more compounds selected from the group consisting of metal oxides, metal nitrides and silicon oxides wherein the composition continuously changes in a vertical direction, to form a gradient composition.

3. The encapsulation thin film of claim 1 or 2, wherein the encapsulation thin film has a transmittance equal to or greater than 85% in the visible region.

4. The encapsulation thin film of any of claims 1-3, wherein the anchoring layer (20) is formed of a polysiloxane represented by the following Formula (1): 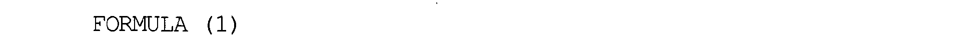 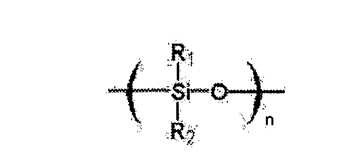 wherein R₁ and R₂ are each independently a hydrogen atom, a C₁-C₃ alkyl group, a C₃-C₁₀ cycloalkyl group or a C₆-C₁₅ aryl group, and n is an integer from 2,000 to 200,000.

5. The encapsulation thin film of any of claims 1-3, wherein the anchoring layer (20) is formed of a polysilsesquioxane represented by the following Formula (2): 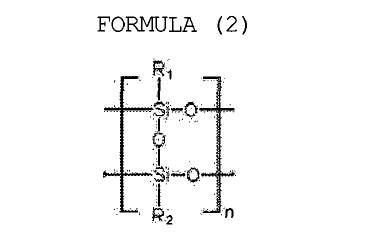 wherein R₁ and R₂ are each independently a hydrogen atom, a C₁-C₃ alkyl group, a C₃-C₁₀ cycloalkyl group or a C₆-C₁₅ aryl group, and n is an integer from 2,000 to 200,000.

6. The encapsulation thin film of any of claims 1-3, wherein the anchoring layer (20) is formed of a polysilazane represented by the following Formula (3):
FORMULA (3) - (SiR₁R₂-NR₃)ₙ-
wherein R₁, R₂ and R₃, which are the same or different, and are each independently a hydrogen atom, a C₁-C₅ alkyl group, a C₂-C₅ alkenyl group, a C₂-C₅ alkynyl group, an alkoxy group, or a C₃-C₈ aromatic group, wherein at least one of R₁, R₂ or R₃ is a hydrogen atom, and n is an integer from 500 to 1,000,000.

7. The graded composition encapsulation thin film of claim 1,
wherein the graded composition layer (30) includes two or more compounds selected from the group consisting of metal oxides, metal nitrides and silicon oxides, wherein a composition of the graded composition layer continuously changes in a vertical direction to form a compositional gradient, and wherein the graded composition layer is continuous with no observable interface.

8. A method for the fabrication of a graded composition encapsulation thin film, the method comprising:
coating a Si-containing organic-inorganic hybrid polymer on a substrate (10) and heat-curing the coating to form an anchoring layer (20); and
forming a graded composition layer (30) on the anchoring layer by physical vapor deposition (PVD) by multi-target PVD deposition.

9. The method of claim 8, wherein the graded composition layer (30) includes two or more compounds selected from the group consisting of metal oxides, metal nitrides and silicon oxides whose composition continuously changes in the vertical direction to form a compositional gradient.

10. The method of claim 8 or 9, wherein the encapsulation thin film has a light transmittance greater than or equal to 85% in the visible region.

11. The method of any of claims 8-10, wherein the PVD process is carried out by sputtering, pulsed laser deposition (PLD), ion beam deposition (IBD) or ion beam assisted deposition (IBAD).

12. The method of any of claims 8-10, wherein the PVD process is carried out by co-sputtering, co-pulsed laser deposition (co-PLD), co-ion beam deposition (co-IBD) or co-ion beam assisted deposition (co-IBAD).

13. The method of claim 12, wherein the co-sputtering is carried out by varying RF power levels at constant power and time intervals to form the compositional gradient of the graded composition layer.

14. An electronic device comprising the encapsulation thin film according to any of claims 1-7.

15. The electronic device of claim 14, wherein the electronic device is an organic light-emitting device, a display device, a photovoltaic device, an integrated circuit, a pressure device, a chemosensor, a biosensor, a solar-powered device or a sensor for lighting.

## Patentansprüche

1. Eine Dünnschichtkapselung mit abgestufter Zusammensetzung, umfassend ein Trägermaterial (10), eine Verankerungsschicht (20), gebildet auf einer Oberfläche des Trägermaterials, und eine Schicht mit abgestufter Zusammensetzung (30), gebildet auf einer Oberfläche der Verankerungsschicht, die dem Trägermaterial gegenüber liegt, wobei die Verankerungsschicht aus einem Si-enthaltenden organisch-anorganischen Hybridpolymer gebildet wird.

2. Die Dünnschichtkapselung in Übereinstimmung mit Anspruch 1, wobei die Schicht mit abgestufter Zusammensetzung (30) zwei oder mehr Verbindungen ausgewählt aus der Gruppe bestehend aus Metalloxiden, Metallnitriden und Siliziumoxiden enthält, wobei sich die Zusammensetzung kontinuierlich in vertikaler Richtung verändert, um eine abgestufte Zusammensetzung zu bilden.

3. Die Dünnschichtkapselung in Übereinstimmung mit Anspruch 1 oder 2, wobei die Dünnschichtkapselung über einen Transmissionsgrad verfügt, der im sichtbaren Bereich gleich oder größer als 85 % ist.

4. Die Dünnschichtkapselung in Übereinstimmung mit einem der Ansprüche 1-3, wobei die Verankerungsschicht (20) aus einem Polysiloxan gebildet wird, das mit der folgenden Formel (1) dargestellt werden kann: 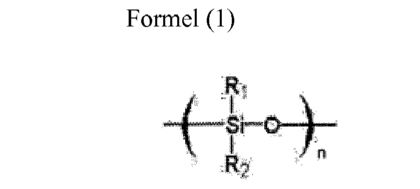 wobei es sich bei R₁ und R₂ jeweils unabhängig voneinander um ein Wasserstoffatom, eine C₁-C₃-Alkylgruppe, eine C₃-C₁₀-Cycloalkylgruppe oder eine C₆-C₁₅-Arylgruppe handelt und n eine Ganzzahl zwischen 2.000 und 200.000 ist.

5. Die Dünnschichtkapselung in Übereinstimmung mit einem der Ansprüche 1-3, wobei die Verankerungsschicht (20) aus einem Polysilsesquioxan gebildet wird, das mit der folgenden Formel (2) dargestellt werden kann: 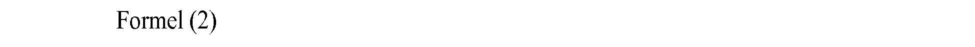 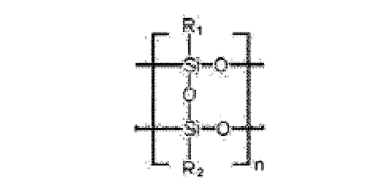 wobei es sich bei R₁ und R₂ jeweils unabhängig voneinander um ein Wasserstoffatom, eine C₁-C₃-Alkylgruppe, eine C₃-C₁₀-Cycloalkylgruppe oder eine C₆-C₁₅-Arylgruppe handelt und n eine Ganzzahl zwischen 2.000 und 200.000 ist.

6. Die Dünnschichtkapselung in Übereinstimmung mit einem der Ansprüche 1-3, wobei die Verankerungsschicht (20) aus einem Polysilazan gebildet wird, das mit der folgenden Formel (3) dargestellt werden kann:
Formel (3) - (SiR₁R₂-NR₃)ₙ -
wobei es sich bei R₁, R₂ und R₃, die gleich oder unterschiedlich sind, jeweils unabhängig voneinander um ein Wasserstoffatom, eine C₁-C₅-Alkylgruppe, eine C₂-C₅-Alkenylgruppe, eine C₂-C₅-Alkynylgruppe, eine Alkoxygruppe oder eine C₃-C₈-aromatische Gruppe handelt, wobei es sich mindestens entweder bei R₁, R₂ oder R₃ um ein Wasserstoffatom handelt, und n eine Ganzzahl zwischen 500 und 1.000.000 ist.

7. Die Dünnschichtkapselung mit abgestufter Zusammensetzung in Übereinstimmung mit Anspruch 1,
wobei die Schicht mit abgestufter Zusammensetzung (30) zwei oder mehr Verbindungen ausgewählt aus der Gruppe bestehend aus Metalloxiden, Metallnitriden und Siliziumoxiden enthält, wobei sich die Zusammensetzung der Schicht mit abgestufter Zusammensetzung kontinuierlich in vertikaler Richtung verändert, um einen kompositorischen Anstieg zu bilden, und wobei die Schicht mit abgestufter Zusammensetzung ohne erkennbare Schnittstelle kontinuierlich verläuft.

8. Ein Verfahren zur Herstellung einer Dünnschichtkapselung mit abgestufter Zusammensetzung, wobei das Verfahren Folgendes umfasst:
die Aufbringung eines Si-enthaltenden organisch-anorganischen Hybridpolymers auf ein Trägermaterial (10) und die Aushärtung der Beschichtung durch Wärmebehandlung, um eine Verankerungsschicht (20) zu erhalten; und
die Ausbildung einer Schicht mit abgestufter Zusammensetzung (30) auf der Verankerungsschicht durch physikalische Gasphasenabscheidung (PGA) mittels Gasphasenabscheidung an mehreren Zielen.

9. Das Verfahren in Übereinstimmung mit Anspruch 8, wobei die Schicht mit abgestufter Zusammensetzung (30) zwei oder mehr Verbindungen ausgewählt aus der Gruppe bestehend aus Metalloxiden, Metallnitriden und Siliziumoxiden enthält, deren Zusammensetzung sich kontinuierlich in vertikaler Richtung verändert, um einen kompositorischen Anstieg zu bilden.

10. Das Verfahren in Übereinstimmung mit Anspruch 8 oder 9, wobei die Dünnschichtkapselung über einen Lichttransmissionsgrad verfügt, der im sichtbaren Bereich gleich oder größer als 85 % ist.

11. Das Verfahren in Übereinstimmung mit einem der Ansprüche 8-10, wobei die PGA durch Kathodenzerstäubung, Laserverdampfung (PLD), Ionenstrahlbeschichtung (IBD) oder Ionenstrahl-unterstützte Beschichtung (IBAD) erfolgt.

12. Das Verfahren in Übereinstimmung mit einem der Ansprüche 8-10, wobei die PGA durch Co-Kathodenzerstäubung, Co-Laserverdampfung (co-PLD), Co-Ionenstrahlbeschichtung (co-IBD) oder Co-Ionenstrahl-unterstützte Beschichtung (co-IBAD) erfolgt.

13. Das Verfahren in Übereinstimmung mit Anspruch 12, wobei die Co-Kathodenzerstäubung bei konstanter Leistung und konstanten Zeitintervallen mit unterschiedlichen RF-Niveaus durchgeführt wird, um den kompositorischen Anstieg der Schicht mit abgestufter Zusammensetzung zu bilden.

14. Ein elektronisches Gerät, umfassend die Dünnschichtkapselung in Übereinstimmung mit einem der Ansprüche 1-7.

15. Das elektronische Gerät in Übereinstimmung mit Anspruch 14, wobei es sich bei dem elektronischen Gerät um ein organisches Leuchtgerät, ein Anzeigegerät, ein Photovoltaikgerät, einen integrierten Schaltkreis, ein Druckgerät, einen Chemosensor, einen Biosensor, ein solarbetriebenes Gerät oder einen Beleuchtungssensor handelt.

## Revendications

1. Film mince à encapsulation de composition graduée comprenant un substrat (10), une couche d'ancrage (20) formée sur une surface du substrat et une couche de composition graduée (30) formée sur une surface de la couche d'ancrage opposée au substrat, où la couche d'ancrage est constituée d'un polymère hybride organique-inorganique contenant du Si.

2. Film mince à encapsulation selon la revendication 1, où la couche de composition graduée (30) contient deux ou plusieurs composés sélectionnés parmi le groupe consistant en oxydes métalliques, nitrures métalliques et oxydes de silicium où la composition change continuellement de direction verticale, pour former une composition à gradient.

3. Film mince à encapsulation selon la revendication 1 ou la revendication 2, où le film mince à encapsulation Présente une transmittance supérieure ou égale à 85% dans la région visible.

4. Film mince à encapsulation selon l'une quelconque des revendications 1 à 3, où la couche d'ancrage (20) est constituée d'un polysiloxane représenté par la formule suivante (1): 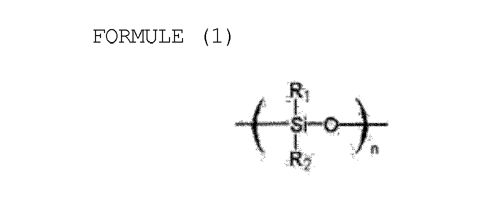 où R₁ et R₂ sont chacun indépendamment un atome d'hydrogène, un groupe alkyle C₁-C₃, un groupe cycloalkyle C₃-C₁₀ ou un groupe aryle C₆-C₁₅ et n est un entier compris entre 2000 et 200.000.

5. Film mince à encapsulation selon l'une quelconque des revendications 1 à 3, où la couche d'ancrage (20) est constituée d'un polysilsesquioxane représenté par la formule suivante (2): 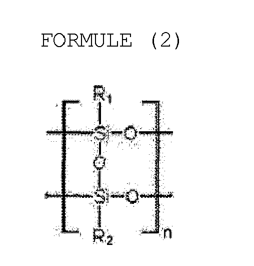 où R₁ et R₂ sont chacun indépendamment un atome d'hydrogène, un groupe alkyle C₁-C₃, un groupe cycloalkyle C₃-C₁₀ ou un groupe aryle C₆-C₁₅ et n est un entier compris entre 2000 et 200.000.

6. Film mince à encapsulation selon l'une quelconque des revendications 1 à 3, où la couche d'ancrage (20) est constituée d'un polysilazane représenté par la formule suivante (3):
FORMULE (3) - (SiR₁R₂-NR₃)ₙ-
où R₁, R₂ et R₃, qui sont identiques ou différents, et sont chacun indépendamment un atome d'hydrogène, un groupe alkyle C₁-C₅, un groupe alkényle C₂-C₅, un groupe alkynyle C₂-C₅, un groupe alkoxy ou un groupe aromatique C₃-C₈, où au moins l'une de R₁, R₂ ou R₃ est un atome d'hydrogène, et n est un entier de 500 à 1000000.

7. Film mince à encapsulation de composition graduée selon la revendication 1,
où la couche de composition graduée (30) contient deux ou plusieurs composés sélectionnés parmi le groupe consistant en oxydes métalliques, nitrures métalliques et oxydes de silicium où une composition de la couche de composition graduée change continuellement de direction verticale, pour former un gradient de composition, et où la couche de composition graduée est continue sans interface observable.

8. Procédé de fabrication d'un film mince à encapsulation de composition graduée, procédé consistant à:
enduire un polymère hybride organique-inorganique contenant du Si sur un substrat (10) et vulcaniser le revêtement pour constituent une couche d'ancrage (20) ; et
former une couche de composition graduée (30) sur la couche d'ancrage par dépôt physique en phase vapeur (PVD) par dépôt PVD multicible.

9. Procédé selon la revendication 8, où la couche de composition graduée (30) comprend deux ou plusieurs composés sélectionnés parmi le groupe consistant en oxydes métalliques, nitrures métalliques et oxydes de silicium dont la composition continuellement change dans la direction verticale pour constituer un gradient de composition.

10. Procédé selon la revendication 8 ou la revendication 9, où le film mince à encapsulation présente une transmittance supérieure ou égale à 85% dans la région visible.

11. Procédé selon l'une quelconque des revendications 8 à 10, où le procédé PVD s'effectue par pulvérisation cathodique, dépôt à laser pulsé (PLD), dépôt par faisceau ionique (IBD) ou dépôt assisté par faisceau ionique (IBAD).

12. Procédé selon l'une quelconque des revendications 8 à 10, où le procédé PVD s'effectue par co-pulvérisation cathodique, dépôt à laser co-pulsé (co-PLD), dépôt par faisceau co-ionique (co-IBD) ou dépôt assisté par faisceau co-ionique (co-IBAD).

13. Procédé selon la revendication 12, où la co-pulvé-risation cathodique consiste à faire varier les niveaux de puissance RF à puissance constante et intervalles de temps constants pour constituer le gradient de composition de la couche de composition graduée.

14. Dispositif électronique comprenant le film mince à encapsulation selon l'une quelconque des revendications 1 à 7.

15. Dispositif électronique selon la revendication 14, où le dispositif électronique est un dispositif électroluminescent organique, un dispositif d'affichage, un dispositif photo-voltaïque, un circuit intégré, un dispositif à pression, un capteur chimique, un biocapteur, un dispositif à alimentation solaire ou un capteur d'éclairage.
